# EUROPÄISCHE PATENTSCHRIFT

(11) **EP 4 088 124 B1**
(45) Veröffentlichungstag und Bekanntmachung des Hinweises auf die Patenterteilung: **06.05.2026**
(21) Anmeldenummer: 21700391.2
(22) Anmeldetag: 08.01.2021
(51) Int. Cl.: G01R 17/18

(54) **HOCHSTROMQUELLE FÜR EIN PRÜFSYSTEM ZUR PRÜFUNG EINER ELEKTROENERGIEEINRICHTUNG SOWIE PRÜFSYSTEM**
HIGH CURRENT SOURCE FOR A TEST SYSTEM FOR TESTING AN ELECTRICAL POWER DEVICE, AND TEST SYSTEM
SOURCE DE COURANT FORT POUR UN SYSTÈME DE CONTRÔLE SERVANT À CONTRÔLER UN DISPOSITIF À ÉNERGIE ÉLECTRIQUE ET SYSTÈME DE CONTRÔLE

(30) Priorität: 10.01.2020 AT 500122020
(43) Veröffentlichungstag der Anmeldung: 16.11.2022
(73) Patentinhaber: Omicron electronics GmbH, 6833 Klaus (AT)
(72) Erfinder: BITSCHNAU, Lukas, 6751 Braz (AT); SCHEDLER, Horst, 6830 Rankweil (AT)
(74) Vertreter: Kraus & Lederer PartGmbB
(86) Internationale Anmeldenummer: PCT/EP2021/050292
(87) Internationale Veröffentlichungsnummer: WO 2021/140211

(56) Entgegenhaltungen:
- DE-A1- 102012 222 944
- DE-A1- 102014 119 531

## Beschreibung

### GEBIET DER ERFINDUNG

Die Erfindung liegt auf dem Gebiet der Hochstrommesstechnik und betrifft insbesondere eine Hochstromquelle für ein Prüfsystem zur Prüfung einer Elektroenergieeinrichtung und ein Prüfsystem mit einer solchen Hochstromquelle.

### HINTERGRUND

In elektrischen Energieversorgungsnetzen werden üblicherweise Elektroenergieeinrichtungen wie Leistungstransformatoren oder Schaltanlagen zum Wandeln und Verteilen von elektrischer Energie eingesetzt. Auch werden hierbei gewöhnlich weitere Elektroenergieeinrichtungen wie Hochspannungswandler oder Hochstromwandler - etwa als Messwandler zum Messen von in einem Stromnetz auftretenden Spannungen und Strömen -, Leistungsschalter - wie Primärrelais oder Sekundärrelais, oder etwa zum Verteilen von elektrischer Energie oder als Bestandteile eine Schutzsystems - und Leistungsgeneratoren eingesetzt. Auch im industriellen Umfeld, insbesondere zur Produktion, finden solche Elektroenergieeinrichtungen oder weitere Elektroenergieeinrichtungen wie elektrische (Leistungs-) Motoren Anwendung.

Zur Inbetriebnahme oder zur Wartung von Anlagen mit solchen Elektroenergieeinrichtungen kann es erforderlich sein, deren Funktionen und Eigenschaften zu überprüfen. Hierbei können etwa elektrische Kontakte, das Schaltverhalten oder das Leitverhalten von einer Elektroenergieeinrichtung - wie einem Leistungsschalter, einem Transformator mit etwaigen Stufenschaltern, einer Erdungsanlage oder einer rotierenden Maschine etwa von einem Generator oder einem Elektromotoretwa mittels einer Messung des Widerstands mit einem Prüfstrom überprüft werden. Auch kann hierbei etwa mit einem Prüfstrom ein Übersetzungsverhältnis von einer Elektroenergieeinrichtung - wie einem Leistungstransformator oder einem Stromwandler - gemessen werden. Derartige Messungen können besonders relevant sein, da sich diese Funktionen und Eigenschaften etwa durch Alterung, Transportschäden, Herstellungsfehler, Kurzschlüsse oder einer Magnetisierung eines (Transformator-) Kerns ändern können und folglich ein regelmäßiges Monitoring zur Sicherstellung der Betriebssicherheit der Elektroenergieeinrichtung sowie der entsprechenden Hochspannungsanlage nötig sein kann.

Derartige Messungen werden häufig im Feldeinsatz - also im Außenbereich oder in einer industriellen Umgebung - durchgeführt. Dabei sollen die verwendeten Gerätschaften besonders für den Feldeinsatz ein geringes Gewicht haben und für den Transport zum jeweiligen Einsatzort robust sein. Dokument DE102012222944 offenbart eine Schaltungsanordnung zur Versorgung eines Aggregats in einem Kraftfahrzeug mit Strom, mit wenigstens zwei parallel geschalteten Halbbrücken aufweisend jeweils zwei Transistoren, wobei jede der wenigstens zwei Halbbrücken in einem H-Brücken-Schaltungsbaustein integriert ist, der eine integrierte Recheneinheit aufweist, die dazu eingerichtet ist, einen aktiven Freilauf für die integrierte Halbbrücke nach Maßgabe eines Aktivierungssignals zu aktivieren oder zu deaktivieren.

### ZUSAMMENFASSUNG DER ERFINDUNG

Es besteht daher Bedarf, ein Prüfen von Funktionen und Eigenschaften von Elektroenergieeinrichtungen mit einem Prüfstrom zu verbessern und dabei insbesondere eine Hochstromquelle hierfür und ein Prüfsystem robuster, einfacher transportierbar, verlässlicher oder sicherer zu machen.

Die Erfindung erfüllt diesen Bedarf jeweils durch eine Hochstromquelle für ein Prüfsystem zur Prüfung einer Elektroenergieeinrichtung gemäß Anspruch 1, durch ein Prüfsystem gemäß Anspruch 15 zur Prüfung einer Elektroenergieeinrichtung mit einem Prüfstrom sowie durch eine Verwendung einer solchen Hochstromquelle oder eines solchen Prüfsystems zur Prüfung einer Elektroenergieeinrichtung mit einem Prüfstrom gemäß Anspruch 16. Vorteilhafte Ausführungsformen der vorliegenden Erfindung sind Gegenstand der abhängigen Ansprüche.

Ein erster Aspekt der Erfindung betrifft eine Hochstromquelle für ein Prüfsystem zur Prüfung einer Elektroenergieeinrichtung. Die Hochstromquelle weist eine erste Vielzahl an ersten schaltbaren Halbbrücken, die parallel geschaltet sind und durch deren Anzahl ein Prüfstrom redundant aufgeteilt wird, auf. Zudem weist die Hochstromquelle eine zweite Vielzahl an zweiten schaltbaren Halbbrücken, die parallel geschaltet sind und durch deren Anzahl der Prüfstrom redundant aufgeteilt wird, auf. Eine Ansteuerungseinrichtung der Hochstromquelle ist eingerichtet, basierend auf einem Eingangssignal die erste Vielzahl an ersten schaltbaren Halbbrücken und die zweite Vielzahl an zweiten schaltbaren Halbbrücken derart anzusteuern, dass an einem Brückenzweig zwischen den ersten schaltbaren Halbbrücken und den zweiten schaltbaren Halbbrücken ein Ausgangssignal für den Prüfstrom anliegt, welches dem Eingangssignal entspricht.

Ein Vorteil der Hochstromquelle und des damit hohen maximal erzeugbaren Stroms als Prüfstrom - etwa 500 A oder sogar im kA-Bereich - kann insbesondere darin liegen, dass es ermöglicht wird, die Elektroenergieeinrichtung mit einem Prüfstrom zu prüfen, der einem Nennstrom für den Betrieb der Elektroenergieeinrichtung entspricht oder zumindest so hoch ist, dass bei der Prüfung bestimmte Funktionen und Eigenschaften der Elektroenergieeinrichtung zumindest im Wesentlichen den Funktionen und Eigenschaften im Betrieb entsprechen.

Ein Vorteil des redundanten Aufteilens des Prüfstroms kann insbesondere darin liegen, dass sich auch bei Ausfall einzelner schaltbarer Halbbrücken der Prüfstrom noch erzeugen lässt, wodurch insbesondere die Prüfung verlässlicher durchgeführt werden kann und die Robustheit der Hochstromquelle gesteigert werden kann. Besonders im Feldeinsatz oder durch hohe Prüfströme können Prüfvorrichtungen wie die Hochstromquelle - etwa mechanisch beim Transport oder thermisch im Betrieb - belastet werden, was zum Ausfall einzelner Halbbrücken führen könnte, sodass sich durch die Redundanz auch eine verlängerte Lebensdauer der Hochstromquelle erzielen lässt.

Durch das Aufteilen des Prüfstrom lassen sich die thermische und/oder elektrische Belastung von Komponenten der Hochstromquelle, insbesondere von den schaltbaren Halbbrücken reduzieren und so die Hochstromquelle verlässlicher machen, Ausfälle reduzieren und/oder bessere Prüfungen, insbesondere mit höheren Strömen oder kürzeren Wartezeiten - etwa zur Kühlung -, ausführen.

Durch das Erzeugen des Prüfstroms am Brückenzweig lässt sich eine höhere Spannungsamplitude und damit ein höherer (maximaler) Strom bei vorbestimmter Betriebsspannung der Hochstromquelle erzielen und, insbesondere da bei symmetrischer Betriebsspannung nur etwa die Hälfte der ansonsten erforderlichen Spannungsamplitude relativ zu einem Erdpotential je auf Seite der ersten schaltbaren Halbbrücken und auf Seite der zweiten schaltbaren Halbbrücken anliegen muss, die Betriebssicherheit steigern.

Ein Vorteil des Erzeugens des Prüfstroms mittels der ersten Vielzahl und zweiten Vielzahl an schaltbaren Halbbrücken - insbesondere zum Erzeugen eines Prüfstroms mittels eines Hochstromtransformators - kann insbesondere darin liegen, dass sich das Gewicht reduzieren lässt, womit insbesondere die Hochstromquelle oder ein Prüfsystem mit einem solchen leichter und damit leichter transportierbar ist, was besonders im Feldeinsatz aber auch ansonsten bei der Verwendung vorteilhaft sein kann. So können einige Varianten der Hochstromquelle ein Gewicht deutlich kleiner als 10 kg haben.

Im Sinne der Erfindung ist unter einer "Hochstromquelle" zumindest eine Stromquelle zu verstehen, welche eingerichtet ist, einen Hochstrom - also einen Strom mit einem Maximalwert von wenigstens 500 A - bereitzustellen. Dabei kann eine solche Hochstromquelle grundsätzlich - etwa abhängig von ihrer Ansteuerung - auch einen geringeren Strom bereitstellen. Auch kann eine solche Hochstromquelle verschiedene - etwaig manuell oder automatisch auswählbare -Prüfstrombereiche aufweisen. Auch kann die "Hochstromquelle" im Sinne der Erfindung so zu verstehen sein, dass die Hochstromquelle in Form einer baulichen Einheit ausgestaltet ist. Dabei kann die Hochstromquelle als ein Hochstrommodul - etwa als ein Erweiterungsmodul für ein Prüfsystem - eingerichtet sein. Ein solches Erweiterungsmodul kann in einem Modulplatz eines Hauptgeräts des Prüfsystems aufgenommen werden.

Im Sinne der Erfindung ist unter einem "hohen Strom" oder einem "Hochstrom" insbesondere ein elektrischer Strom von wenigstens 500 A zu verstehen. Bei einem elektrischen Wechselstrom kann sich der Wert hierbei auf die Amplitude oder den Effektivwert des Wechselstroms beziehen, bei einem Gleichstrom auf den Gleichstromanteil und ansonsten auf die betragsmäßig größten Spitzenwerte oder Effektivwerte.

Im Sinne der Erfindung ist unter einer "hohen Spannung" oder einer "Hochspannung" insbesondere eine elektrische Spannung von mindestens 1000 V zu verstehen. Bei einer elektrischen Wechselspannung kann sich der Wert hierbei auf die Amplitude oder den Effektivwert der Wechselspannung beziehen, bei einer Gleichspannung auf den Gleichspannungsanteil und ansonsten auf die betragsmäßig größten Spitzenwerte oder Effektivwerte.

Im Sinne der Erfindung ist unter einer "Elektroenergieeinrichtung" eine Einrichtung - etwa als Teil einer Hochspannungsanlage zur Energieversorgung oder als Teil einer elektrisch betriebenen Produktionsanlage - zu verstehen, welche mit einer hohen elektrischen Spannung oder einem hohen elektrischen Strom betrieben wird, eine(n) solchen steuert, wandelt oder misst oder aus einem sonstigen Grund einem hohen elektrischen Strom ausgesetzt sein kann und dabei für einen sicheren Betrieb - etwa durch ausreichende elektrische Leitfähigkeit - eingerichtet sein soll. Auch kann eine Elektroenergieeinrichtung aus einem sonstigen Grund einer hohen elektrischen Spannung ausgesetzt sein und soll dabei für einen sicheren Betrieb - etwa durch ausreichende elektrische Isolierung - eingerichtet sein. Eine Elektroenergieeinrichtung, welche einer hohen elektrischen Spannung ausgesetzt sein kann und dafür eingerichtet ist, wird auch als "Hochspannungseinrichtung" bezeichnet. Insbesondere kann eine solche Elektroenergieeinrichtung ein Leistungstransformator, eine (Hochspannungs-) Schaltanlage, ein (Hochspannungs-) Schutzschalter oder Leistungsschalter wie Primärrelais oder Sekundärrelais, eine Erdungsanlage, eine mit Hochspannung betriebene oder eine hochspannungserzeugende rotierende Maschine wie ein Leistungselektromotor oder ein Leistungsgenerator, ein Stufenschalter für einen Transformator, ein Messwandler wie ein Hochspannungswandler oder ein Hochstromwandler - etwa ein induktiver Stromwandler mit einem Transformatorkern oder mit einer Rogowskispule oder ein nicht-induktiver Stromwandler mittels Feldplatten, Faraday-Effekt etc. - oder ein sonstiger Stromwandler oder Spannungswandler sein. Auch kann insbesondere eine solche Elektroenergieeinrichtung ein sonstiges elektrisches Gerät sein, bei welchem eine Messung mit einem hohen Strom durchzuführen ist. Auch kann insbesondere eine Mikroohm-Messung an einer solchen Elektroenergieeinrichtung mittels des hohen Stroms der Hochstromquelle und einer Messung der dabei auftretenden Spannung durchgeführt werden.

Gemäß einigen Ausführungsformen weisen die ersten schaltbaren Halbbrücken jeweils zwei steuerbare Schaltelemente auf, die je mit einer Verbindungsstelle in Reihe geschaltet sind. Auch weisen die zweiten schaltbaren Halbbrücken jeweils zwei steuerbare Schaltelemente auf, die je mit einer Verbindungsstelle in Reihe geschaltet sind. Dabei sind die Verbindungsstellen der ersten schaltbaren Halbbrücken parallel geschaltet sind und mit einer ersten Seite des Brückenzweigs elektrisch verbunden. Auch sind die Verbindungsstellen der zweiten schaltbaren Halbbrücken parallel geschaltet und mit einer zweiten Seite des Brückenzweigs elektrisch verbunden. Schließlich ist die Ansteuerungseinrichtung eingerichtet, die steuerbaren Schaltelemente anzusteuern.

Ein Vorteil des Brückenzweigs zwischen den ersten und den zweiten schaltbaren Halbbrücken für das Ausgangssignal kann - etwa in vorteilhafter Kombination mit Ausführungsformen, bei welchen die ersten und zweiten schaltbaren Halbbrücken jeweils zwei steuerbare Schaltelemente aufweisen - insbesondere darin liegen, dass für die Hochstromquelle keine Energieversorgungseinrichtung mit einer Mittelanzapfung benötigt wird.

Einige Ausführungsformen, bei welchen die Verbindungsstellen der ersten bzw. zweiten schaltbaren Halbbrücken jeweils über ein Filterelement mit der ersten bzw. zweiten Seite des Brückenzweigs elektrisch verbunden sind, können insbesondere den Vorteil haben, dass sich die einzelnen schaltbaren Halbbrücken - etwa bezüglich ihres Schaltverhaltens - entkoppeln lassen, wodurch sich in einigen Varianten ein synchrones und damit insbesondere einfaches Ansteuern der ersten bzw. zweiten schaltbaren Halbbrücken oder in anderen Varianten ein asynchrones Ansteuern der ersten bzw. zweiten schaltbaren Halbbrücken verbessern lässt. Dabei ist in weiteren Ausführungsformen auch ein synchrones bzw. asynchrones Ansteuern ohne derartige Filterelemente möglich. Bei einigen Varianten mit oder ohne Filterelementen, bei welchen eine asynchrone Ansteuerung erfolgt, ist die Anstellungseinrichtung eingerichtet, die schaltbaren Halbbrücken zeitlich versetzt - etwa mit vorbestimmten Zeitintervallen oder mit einer zufälligen Verteilung - anzusteuern. Bei einigen Varianten mit oder ohne Filterelementen, ist die Ansteuerungseinrichtung eingerichtet, nicht synchronisiert und/oder zufällig anzusteuern.

In einigen Ausführungsformen weisen die schaltbaren Halbbrücken jeweils eine nicht-synchronisierte Hysterese-Spulenstromregelung, insbesondere in Kombination mit jeweils einem LC-Filter, auf. Auf diese vorteilhafte Weise lässt sich der jeweilige Strom durch die jeweilige Halbbrücke selbst-oszillierend regeln.

Ein Vorteil des Erzeugens des Prüfstroms mittels der ersten Vielzahl und zweiten Vielzahl an schaltbaren Halbbrücken - insbesondere zum Erzeugen eines Prüfstroms mittels eines Hochstromtransformators - kann insbesondere darin liegen, dass aufgrund der Vielzahl an schaltbaren Halbbrücken ein gleichzeitiges Takten/Schalten aller Halbbrücken unwahrscheinlich ist.

Ein Vorteil eines (zufällig) versetzten Schaltens der Halbbrücken - etwa aufgrund von zufälliger oder asynchroner Ansteuerung oder jeweiliger Regelung etwa anhand von Hysterese-Spulenstromregelung - kann insbesondere darin liegen, dass eine Stromwelligkeit oder Spannungswelligkeit beim Ausgangssignal, also insbesondere des Prüfstroms, reduziert werden kann.

Einige Ausführungsformen, bei welchen zur Versorgung der schaltbaren Halbbrücken eine Energieversorgungseinrichtung zum Empfangen einer elektrischen Energie und zum Bereitstellen einer galvanisch davon getrennten positiven und negativen Versorgungsspannung eingerichtet ist, können insbesondere den Vorteil haben, dass sich die Betriebssicherheit und/oder die Robustheit - etwa gegenüber eingestreuten oder durch ein Schalten der schaltbaren Halbbrücken verursachten Störungen - erhöhen lässt.

Durch eine galvanische Trennung des Eingangssignals von den schaltbaren Halbbrücken bei einigen Ausführungsformen, wobei in einigen Varianten speziell das Ausgangssignal vom Eingangssignal galvanisch getrennt ist, lässt sich die Betriebssicherheit steigern.

Gemäß einigen Ausführungsformen sind die erste Vielzahl an ersten schaltbaren Halbbrücken und die zweite Vielzahl an schaltbaren Halbbrücken eingerichtet, als Prüfstrom einen hohen Strom in der Größenordnung von wenigstens 500 A oder sogar in den kA-Bereich als den Prüfstrom zu erzeugen.

Gemäß einigen Ausführungsformen ist die Anzahl der ersten schaltbaren Halbbrücken gleich der Anzahl der zweiten schaltbaren Halbbrücken, wodurch vorteilhaft insbesondere ein symmetrischer Aufbau ermöglicht wird.

Gemäß einigen Ausführungsformen weist die erste und/oder zweite Vielzahl eine große Anzahl an ersten bzw. zweiten schaltbaren Halbbrücken auf. In einigen Varianten können die schaltbaren Halbbrücken diskrete Bauteile sein oder aus solchen bestehen. Auch sind in einigen Ausführungsformen alle der ersten und/oder der zweiten schaltbaren Halbbrücken jeweils eingerichtet, einen maximalen Strom von wenigstens 3 A oder von höchstens 200 A zu erzeugen bzw. in einem eingeschalteten Zustand zu leiten. Auf diese vorteilhafte Weise kann die elektrische und/oder thermische Belastung weiter aufgeteilt werden auf, sodass die Belastung von einzelnen - insbesondere diskreten Bauteilen - reduziert werden kann und nur einen kleinen Bruchteil des Gesamtbelastung ausmacht. Auch können Varianten mit einer größeren Anzahl an ersten bzw. zweiten schaltbaren Halbbrücken, etwa 20, 40 oder mehr erste schaltbare Halbbrücken und/oder etwa 20, 40 oder mehr zweite schaltbare Halbbrücken, - insbesondere für höhere Prüfströme - weiter vorteilhaft sein. In Kombination mit dem redundanten Aufteilen kann ein Vorteil insbesondere der gesteigerten Ausfallsicherheit und/oder der gesteigerten Robustheit - besonders für den Feldeinsatz - liegen.

Ein zweiter Aspekt der Erfindung betrifft ein Prüfsystem zur Prüfung einer Elektroenergieeinrichtung mit einem Prüfstrom. Das Prüfsystem weist ein portables Hauptgerät mit einem Gehäuse, das einen Modulplatz zur Aufnahme und zur Verbindung mit einem Erweiterungsmodul aufweist, und mit einer am Gehäuse angeordneten Anschlussanordnung zur Verbindung mit einem portablen Zusatzgerät auf. Zudem weist das Prüfsystem als das Erweiterungsmodul eine Hochstromquelle gemäß dem ersten Aspekt der Erfindung auf. Weiterhin weist die Hochstromquelle ein Gehäuse für den Modulplatz auf sowie am Gehäuse angeordnet eine Energieversorgungsanschlussanordnung, eine Eingangsanschlussanordnung und einen ersten und einen zweiten Hochstromanschluss. Das portable Hauptgerät weist weiterhin eine Messeinrichtung für ein Messen von Messgrößen und eine Steuerungseinrichtung zum Steuern der Messeinrichtung und der Hochstromquelle für eine Prüfung der Elektroenergieeinrichtung auf. Dabei ist das portable Hauptgerät eingerichtet, die Hochstromquelle, wenn sie im Modulplatz aufgenommen ist, über die Eingangsanschlussanordnung zu steuern und über die Energieversorgungsanschlussanordnung mit Energie zu versorgen. Auch ist dabei die Hochstromquelle eingerichtet, gesteuert durch die Steuerungseinrichtung ein Ausgangssignal zwischen dem ersten und zweiten Hochstromanschluss zu erzeugen und somit den Prüfstrom bereitzustellen.

Die bereits vorausgehend genannten möglichen Vorteile, Ausführungsformen, Weiterbildungen oder Varianten des ersten Aspekts der Erfindung gelten entsprechend auch für das erfindungsgemäße Prüfsystem.

Einige Ausführungsformen, bei welchen der Modulplatz einen Aufnahmeschacht für die Hochstromquelle aufweist oder daraus besteht, können insbesondere den Vorteil haben, dass Außenabmessungen des portablen Hauptgeräts oder eine Umhüllende des portablen Hauptgeräts durch Aufnahme der Hochstromquelle oder durch Weglassen der Hochstromquelle zumindest im Wesentlichen nicht geändert werden, womit sich insbesondere die Handhabung vereinfachen lässt.

Ein dritter Aspekt der Erfindung betrifft eine Verwendung eine Hochstromquelle gemäß dem ersten Aspekt der Erfindung oder eines Prüfsystems gemäß dem zweiten Aspekt der Erfindung zur Prüfung einer Elektroenergieeinrichtung mit einem Prüfstrom. Hierbei ist die Hochstromquelle bzw. die Hochstromquelle des Prüfsystems eingerichtet, den Prüfstrom zu erzeugen. Zudem wird vorzugsweise mittels einer Messeinrichtung der Hochstromquelle oder des Prüfsystems wenigstens eine auf Grundlage des Prüfstroms erzeugte Messgröße für die Prüfung gemessen.

Die bereits vorausgehend genannten möglichen Vorteile, Ausführungsformen, Weiterbildungen oder Varianten der vorhergehenden Aspekte der Erfindung gelten entsprechend auch für die erfindungsgemäße Verwendung.

Weitere Vorteile, Merkmale und Anwendungsmöglichkeiten ergeben sich aus der nachfolgenden detaillierten Beschreibung von Ausführungsbeispielen und/oder aus den Figuren.

### KURZE BESCHREIBUNG DER FIGUREN

Die Erfindung wird nachfolgend unter Bezugnahme auf die Figuren anhand vorteilhafter Ausführungsbeispiele näher erläutert. Gleiche Elemente oder Bauteile der Ausführungsbeispiele werden im Wesentlichen durch gleiche Bezugszeichen gekennzeichnet, falls dies nicht anders beschrieben wird oder sich nicht anders aus dem Kontext ergibt.

Hierzu zeigen schematisiert:
Fig. 1 eine Hochstromquelle nach einer Ausführungsform;
Fig. 2 ein Prüfsystem nach einer Ausführungsform; und
Fig. 3 ein Flussdiagramm einer Verwendung eine Hochstromquelle oder eines Prüfsystems nach einer Ausführungsform.

### DETAILLIERTE BESCHREIBUNG VON AUSFÜHRUNGSBEISPIELEN

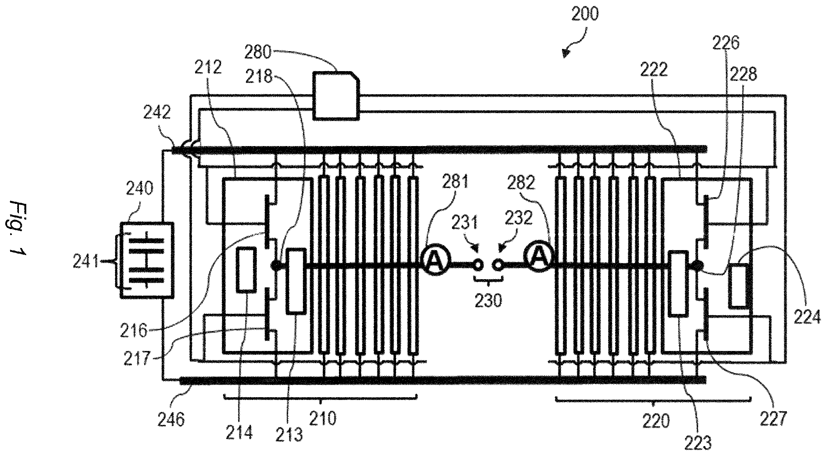

In Fig. 1 ist eine Hochstromquelle 200 nach einer Ausführungsform der vorliegenden Erfindung für ein Prüfsystem zur Prüfung einer Elektroenergieeinrichtung dargestellt.

In einem Ausführungsbeispiel weist die Hochstromquelle 200 eine erste Vielzahl 210 an ersten schaltbaren Halbbrücken 212, eine zweite Vielzahl 220 an zweiten schaltbaren Halbbrücken 222, eine positive Versorgungsschiene 242 und eine negative Versorgungsschiene 246 und eine Ansteuerungseinrichtung 280 auf. Die Ansteuerungseinrichtung 280 ist eingerichtet, basierend auf einem Eingangssignal die erste Vielzahl 210 und die zweite Vielzahl 220 derart anzusteuern, dass an einem Brückenzweig 230 zwischen den ersten und zweiten schaltbaren Halbbrücken ein Ausgangssignal für einen Prüfstrom anliegt, welches dem Eingangssignal entspricht.

Zudem weisen einige Varianten der Hochstromquelle 200 eine Energieversorgungseinrichtung 240 auf, welche mit der positiven und der negativen Versorgungsschiene 242, 246 elektrisch verbunden ist sowie eingerichtet ist, über diese eine positive sowie eine negative Versorgungsspannung für die erste und zweite Vielzahl 210, 220 an ersten bzw. zweiten schaltbaren Halbbrücken bereitzustellen. In anderen Varianten können die positive und negative Versorgungsschiene 242, 246 extern kontaktiert und mit Versorgungsspannungen versorgt werden.

Von den ersten schaltbaren Halbbrücken der ersten Vielzahl 210 ist eine erste schaltbare Halbbrücke 212 detailreicher in Fig. 1 dargestellt. Wie dargestellt, weisen die ersten schaltbaren Halbbrücken jeweils zwei Feldeffekttransistoren 216, 217 - etwa MOS-FETs - auf, die mit einer Verbindungsstelle 218 elektrisch in Reihe geschaltet sind. Die Feldeffekttransistoren 216, 217 bilden je erster schaltbarer Halbbrücke ein steuerbares Schaltelement 216, das mit der positiven Versorgungsschiene 242 elektrisch verbunden, und ein anderes steuerbares Schaltelement 217, das mit der negativen Versorgungsschiene 246 elektrisch verbunden ist, aus. Auch weisen einige Varianten - insbesondere anstatt der Feldeffekttransistoren - andere steuerbare Schaltelemente wie etwa Bipolartransistoren auf.

Die Verbindungsstellen 218 der ersten schaltbaren Halbbrücken 212 sind parallel geschaltet und mit einer ersten Seite 231 des Brückenzweigs 230 elektrisch verbunden. Hierbei können in einigen Varianten die Verbindungsstellen 218 elektrisch direkt miteinander verbunden sein oder alternativ je über ein Filterelement 213 der jeweiligen ersten Halbbrücke 210, 212 mit der ersten Seite 231 verbunden sein. Dabei weist in einigen Varianten das Filterelement 213 einen LC-Filter auf oder besteht daraus.

Zudem weist in einigen Varianten die Hochstromquelle 200 ein gemeinsames erstes Filterelement und/oder eine erste Stromsensoreinrichtung 281 auf, sodass der bei der ersten Seite 231 des Brückenzweigs 230 fließende Strom gefiltert bzw. erfasst werden kann, wodurch sich vorteilhaft insbesondere ein Ausstrahlen von Störungen aufgrund eines Schaltens der steuerbaren Schaltelemente reduzieren bzw. ein tatsächlich fließender Prüfstrom etwa für die Prüfung oder für eine Rückkopplungsschleife bestimmen lässt. Weiterhin weist die erste Stromsensoreinrichtung 281 in einigen Varianten mehrere Stromsensoren auf und ist eingerichtet, den bei der ersten Seite 231 des Brückenzweigs 230 fließenden Strom als Summe der jeweils durch die Stromsensoren fließenden Ströme zu erfassen. Hierzu sind in einigen Varianten die Stromsensoren parallel geschaltet. Alternativ sind in einigen Varianten die Stromsensoren jeweils einer oder mehreren Halbbrücken zugeordnet, sodass diese jeweils einen elektrischen Strom erfassen, welcher bei den jeweiligen Halbbrücken von/zur ersten Seite 231 fließt. Auf diese vorteilhafte Weise lässt sich die Genauigkeit beim Erfassen des Stroms erhöhen und/oder das Gewicht gegenüber einer Stromsensoreinrichtung mit einem einzigen Stromsensor für einen entsprechend höheren Strom reduzieren.

Außerdem weisen die ersten schaltbaren Halbbrücken 210 in einigen Varianten jeweils ein Regelungselement 214 auf, welches eingerichtet ist, ein Schalten der steuerbaren Schaltelemente 216, 217 mittels einer - insbesondere selbst-oszillierenden und nicht mit den jeweils anderen Regelungselementen 214 synchronisierten - Hysterese-Spulenstromregelung und etwa basierend auf einem Signal von einer Spule des Filterelements 213, insbesondere der Spule des LC-Filters, zu regeln.

Entsprechendes gilt für die zweite Vielzahl 220 an zweiten schaltbaren Halbbrücken, wobei von den zweiten schaltbaren Halbbrücken eine zweite schaltbare Halbbrücke 222 detailreicher in Fig. 1 dargestellt ist und diese zweiten schaltbaren Halbbrücken jeweils zwei Feldeffekttransistoren (oder allgemeiner steuerbare Schaltelemente) 226, 227 aufweisen, die jeweils über eine Verbindungsstelle 228 in Reihe zwischen die positive 242 und negative 246 Versorgungsschiene geschaltet sind. Auch kann die Hochstromquelle 200 entsprechend für eine zweite Seite 232 des Brückenzweigs 230, mit welcher die Verbindungsstellen 228 elektrisch verbunden sind, ein gemeinsames zweites Filterelement und/oder eine zweite Stromsensoreinrichtung 282 aufweisen. Auch können die zweiten Halbbrücken 220 jeweils ein Regelungselement 224 aufweisen und/oder ein Filterelement 223, über welches sie mit der zweiten Seite 232 elektrisch verbunden sind.

In Fig. 1 ist je die erste Vielzahl 210 und die zweite Vielzahl 220 dargestellt mit insgesamt jeweils sieben ersten bzw. sieben zweiten schaltbaren Halbbrücken. In weiteren Varianten kann die Anzahl an ersten bzw. zweiten schaltbaren Halbbrücken auch größer sein - etwa vorteilhaft größer oder gleich zehn, zwanzig, vierzig oder achtundvierzig. Hierdurch lässt der zu erzeugende Prüfstrom (noch) weiter aufteilen, die Wahrscheinlichkeit für ein gleichzeitiges Schalten der Halbbrücken reduzieren und somit die Strom- oder Spannungswelligkeit reduzieren und/oder auch bei Ausfall von einzelnen Halbbrücken weiterhin der Prüfstrom bis zu einem vorbestimmten maximalen Strom erzeugen.

In einigen Varianten, bei welchen die erste und zweite Vielzahl 210, 220 eingerichtet sind, einen maximalen Strom von wenigstens 1 kA als den Prüfstrom zu erzeugen, wobei die Halbbrücken jeweils für einen maximalen Strom von etwa oder genau 25 A ausgebildet sind und die Anzahl der ersten und zweiten schaltbaren Halbbrücken jeweils vierzig (oder für zusätzliche Redundanz achtundvierzig) ist, wodurch der bereitzustellende Prüfstrom auf vierzig 25 A-Halbbrücken aufgeteilt wird sowie ggf. ein Reservebereich von 200 A - etwa als Redundanz oder für (kurzzeitige) Überlast - bleibt. Bei einer solchen Variante mit vierzig ersten und vierzig zweiten Halbbrücken - also insgesamt achtzig Halbbrücken - für 1 kA als Prüfstrom sowie mit einer ersten Stromsensoreinrichtung 281 und einer zweiten Stromsensoreinrichtung 282 weist die erste Stromsensoreinrichtung 281 zehn Stromsensoren auf, wobei jeweils ein erster der Stromsensoren eingerichtet ist, einen Strom von einer ersten Gruppe von vier der ersten Halbbrücken zu erfassen, ein zweiter der Stromsensoren zur Erfassung von Strom von einer zweiten Gruppe von weiteren vier der ersten Halbbrücken eingerichtet ist usf., und weist die zweite Stromsensoreinrichtung 282 entsprechende zehn Stromsensoren auf. Durch das Aufteilen des Erfassens des Stroms auf mehrere Stromsensoren lässt sich gegenüber einem einzelnen Stromsensor für einen entsprechend höheren Strom vorteilhaft das Gewicht reduzieren.

Bei einigen Varianten, bei welchen die erste/zweite Stromsensoreinrichtung 281/282 mehrere Stromsensoren aufweist und insbesondere die Hochstromquelle mehrere Betriebsbereiche aufweist, weist die erste Stromsensoreinrichtung 281 (und entsprechend die zweite Stromsensoreinrichtung 282) einen zusätzlichen Stromsensor auf. Dabei ist die Stromsensoreinrichtung 281 bzw. 282 eingerichtet, - insbesondere für einen Betriebsbereich mit einem geringeren maximalen Prüfstrom, wie etwa 100 A - zumindest bis zu einem vorbestimmten Maximalstrom wie etwa 100 A den Strom bei der ersten 231 bzw. zweiten 232 Seite mittels des zusätzlichen Stromsensors zu erfassen. Auf diese vorteilhafte Weise lässt sich die Genauigkeit erhöhen. Des Weiteren lässt sich bei Varianten mit einem Betriebsbereich für einen geringeren maximalen Prüfstrom die Betriebssicherheit erhöhen, indem der maximale Prüfstrom auf den geringeren maximalen Prüfstrom begrenzt ist.

In einigen alternativen Varianten weist die Hochstromquelle 200 nur eine Stromsensoreinrichtung, also entweder die Stromsensoreinrichtung 281 oder die Stromsensoreinrichtung 282 auf, wodurch sich das Gewicht vorteilhaft weiter reduzieren lässt. Ein Vorteil von Varianten mit beiden Stromsensoreinrichtungen 281, 282 kann insbesondere darin liegen, dass asymmetrische Stromflüsse erfasst werden können.

In einigen Varianten sind die ersten und zweiten steuerbaren Schaltelemente 216, 217, 226, 227 jeweils diskrete Bauteile, wodurch sich insbesondere die thermische Belastung besser aufteilen lässt. Auch können in weiteren Varianten jeweils mehrere - etwa zwei, vier, sechs oder zehn - der steuerbaren Schaltelemente jeweils zu einem diskreten Bauteil zusammengefasst sein.

In einigen Varianten sind die Halbbrücken jeweils in SMD-Technik ("Surface-mounted device", also mit oberflächenmontierten Bauelementen) auf je einer Leiterplatte oder auf einer oder mehreren gemeinsamen Leiterplatten aufgebaut. Auf diese Weise lässt sich vorteilhaft ein gewichtsmäßig leichter und günstiger Aufbau erzielen und/oder die Kühlung der Bauelemente mittels der Leiterplatte und etwaig einem Luftstrom über die Bauelemente realisieren.

Schließlich ist die Ansteuerungseinrichtung 280 eingerichtet, die steuerbaren Schaltelemente 216, 217, 226, 227 - etwa über Steuerleitungen - derart anzusteuern, dass diese abhängig vom Verlauf des Eingangssignals - und in Varianten mit Rückkopplungsschleife außerdem abhängig vom Ausgangssignal - leitend oder nicht-leitend geschaltet werden und so - nach etwaiger Filterung durch Filterelemente - das Ausgangssignal zwischen der ersten Seite 231 und der zweiten Seite 232 des Brückenzweigs 230 erzeugen. In einigen Varianten kann die Ansteuerungseinrichtung 280 den Prüfstrom mittels der Stromsensoreinrichtung 281 und/oder der Stromsensoreinrichtung 282 regeln. Zusätzlich oder alternativ kann die Ansteuerungseinrichtung 280 in einigen Varianten den Prüfstrom mittels der Regelungselemente 214 und 224 steuern oder regeln. Hierbei ist die Hochstromquelle 200 - insbesondere die Steuerungseinrichtung 280, die erste Vielzahl 210 und die zweite Vielzahl 220 - eingerichtet, als den Prüfstrom zumindest einen Wechselstrom mit einer maximalen Frequenz von wenigstens 3 kHz oder einen Gleichstrom oder allgemeiner eine frei einstellbare Signalform zu erzeugen. In alternativen Varianten kann die Hochstromquelle auch eingerichtet sein, nur ein Wechselstrom oder einen Wechselstrom mit einer niedrigeren oder höheren maximalen Frequenz zu erzeugen.

Ein Vorteil des Gleichstroms kann insbesondere bei der Verwendung zur Prüfung von Leistungsschaltern - also etwa einer sog. "Circuit-Breaker-Messung" - oder bei der Mikroohm-Messung liegen, womit insbesondere auch ein (Aus-) Schaltverhalten bei Fehlern mit auftretendem Gleichstrom geprüft werden kann. Ein Vorteil von Frequenzen bis wenigstens 3 kHz kann insbesondere bei der Verwendung zur Prüfung eines Übertragungsverhaltens/-verhältnisses - etwa bei einem Stromwandler/Messwandler, also etwa einer sog. "CT-Verhältnis-Messung" - liegen, wobei - insbesondere bei einer sog. "Power-Quality-Messung" - das Übertragungsverhalten frequenzabhängig und ggf. auch lastabhängig überprüft werden kann. Durch Varianten mit frei einstellbaren Signalformen lassen sich ein Gleichstrom und/oder eine oder mehrere Wechselströme mit etwaig verschiedenen Amplituden vorteilhaft überlagern, womit insbesondere ein Messablauf bei zumindest im Wesentlichen gleicher Genauigkeit zeitlich verkürzt oder nicht-lineare Effekte - etwa bei einer "Power-Quality-Messung" - gemessen werden können. Auch kann bei Varianten, welche sowohl den Gleichstrom als auch den Wechselstrom erzeugen können, ein Vorteil darin liegen, dass nach einer Gleichstrom-Messung direkt ohne Änderung der Verkabelung auch eine Wechselstrom-Messung durchgeführt werden kann. So kann etwa bei einem Leistungsschalter, bei dem direkt ein Stromwandler nachgeschaltet ist, eine Mikroohm-Messung mit Gleichstrom durchgeführt werden und direkt anschließend eine Entmagnetisierung mittels Wechselstrom erfolgen, wodurch der Stromwandler wieder einschaltbereit gemacht wird. Zur Entmagnetisierung oder für andere Vorgänge als Teil oder zusätzlich zu einer Messung, kann die Hochstromquelle einen Spannungsmodus als Betriebsmodus aufweisen, bei welchem eine Spannung des Ausgangssignals, insbesondere anstelle des (Prüf-) Stroms, gesteuert bzw. geregelt wird. So kann etwa zur Entmagnetisierung eine Hysteresekurve mit immer kleineren elektrischen Spannungen und damit Strömen durchgefahren werden, um schließlich zu einer Stelle zu gelangen, bei welcher keine Magnetisierung mehr vorliegt. Ein Vorteil eines Prüfstroms mit einem maximalen Strom von wenigstens 1 kA kann insbesondere darin liegen, dass die Elektroenergieeinrichtung lastabhängig überprüft werden kann und/oder der verwendete Prüfstrom bereits in einem Bereich liegen kann, welcher die Elektroenergieeinrichtung nicht beschädigt und/oder einem Nennstrom der Elektroenergieeinrichtung entspricht oder zumindest so nahe am Nennstrom ist, dass eine Genauigkeit bei der Prüfung gesteigert werden kann.

Insbesondere zur Erhöhung der Genauigkeit weisen einige Varianten der Hochstromquelle 200 eine Offset-Regelungseinrichtung auf. Dabei ist die Hochstromquelle 200 und/oder die Ansteuerungseinrichtung 280 eingerichtet, mittels der Offset-Regelungseinrichtung einen (verbleibenden/restlichen) Offset-Gleichstrom oder eine Offset-Gleichspannung oder allgemeiner eine verbleibende Abweichung zwischen dem gemäß dem Eingangssignal zu erzeugenden Ausgangssignal und dem tatsächlich mittels der ersten und zweiten schaltbaren Halbbrücken 210, 220 erzeugten Ausgangssignal auszugleichen. Eine solche Offset-Regelungseinrichtung weist in einigen Varianten eine analoge Regelungseinrichtung auf oder besteht daraus.

Bei einigen Varianten mit Energieversorgungseinrichtung 240 weist die Energieversorgungseinrichtung mehrere Doppelschicht-Kondensatoren 241 auf und ist eingerichtet, die positive und/oder die negative Versorgungsspannung mittels der Doppelschichtkondensatoren 241 zu puffern, wodurch sich (kurzzeitig) höhere Prüfströme bzw. Leistungen erzielen lassen, insbesondere ohne dass für die Energieversorgungseinrichtung ein stärker belastbarer Netzanschluss oder eine (dauerhaft) leistungsfähigere Energieversorgungseinrichtung mit entsprechend höherem Gewicht erforderlich ist. Hierbei können mehrere der Doppelschicht-Kondensatoren 241 elektrisch in Serie geschaltet werden, um eine höhere Spannungsbelastbarkeit zu ermöglichen. Typischerweise haben solche Doppelschicht-Kondensatoren jeweils eine Spannungsbelastbarkeit von etwa 2,5 V. Somit kann mit einer Serie von sechs Doppelschicht-Kondensatoren eine Versorgungsspannung von 15 V gepuffert werden. Ein Vorteil der Erzeugung des Prüfstroms mittels der Vielzahl an ersten bzw. zweiten Halbbrücken in Kombination mit den Doppelschicht-Kondensatoren kann insbesondere darin liegen, dass zum Erzeugen des Prüfstroms keine hohe (positive und/oder negative) Versorgungsspannung benötigt wird und somit die Anzahl an für eine ausreichende Spannungsfestigkeit seriell zu verschaltenden Doppelschicht-Kondensatoren verhältnismäßig gering sein kann, was insbesondere eine Symmetrierung der seriellgeschalteten Doppelschicht-Kondensatoren (etwa mittels Balancer) und somit die Herstellung der Stromquelle erleichtert. Auch kann ein Vorteil davon darin liegen, dass nicht nur eine gepufferte Gleichspannung oder ein gepufferte Gleichstrom bereitgestellt werden kann, sondern auch als Prüfstrom einen Wechselstrom erzeugt werden kann, dessen zur Erzeugung notwendige Energie gepuffert ist. Alternativ oder zusätzlich kann die Energieversorgungseinrichtung zur Pufferung oder zum Bereitstellen von Energie ohne einem Netzanschluss weitere Energiespeicher wie etwa Akkumulatoren aufweisen. Ein Vorteil der Doppelschicht-Kondensatoren kann insbesondere darin liegen, dass diese einen hohen Strom ermöglichen, ein geringes Gewicht haben, eine lange Lebensdauer erreichen und/oder unproblematisch bei Lagerung oder Versand sind.

Bei einigen Varianten mit Energieversorgungseinrichtung 240 weist die Energieversorgungseinrichtung einen bidirektionalen DC/DC Wandler auf. So kann etwa bei einer Variante für einen Prüfstrom von bis zu 1 kA die Energieversorgungseinrichtung 240 eingerichtet sein, mittels des bidirektionalen DC/DC Wandlers die erste und die zweite Vielzahl an Halbbrücken, welche insbesondere über den Brückenzweig 230 zu einer Vollbrücke verschaltet sind, mittels einer Versorgungsspannung, d. h. einer Spannungsdifferenz zwischen der positiven und negativen Versorgungsspannung, von 16 V - und etwaig ohne Mittelanzapfung - versorgen. Vorteilhaft in Kombination mit einer Pufferung kann der bidirektionale DC/DC Wandler eingerichtet sein, einen Strom von bis zu 400 A bereitzustellen. Ein Vorteil des bidirektionalen DC/DC Wandlers kann insbesondere darin liegen, dass elektrische Energie, welche über den Prüfstrom wieder der Hochstromquelle zugeführt wird - etwa bei der Messung an Induktivitäten wie Transformatoren -, wieder zurück gespeist werden kann, insbesondere über ein Netzanschluss in ein Stromnetz, wodurch sich insbesondere die Verlustleistung in der Hochstromquelle und damit die erforderliche Kühlung reduzieren lässt.

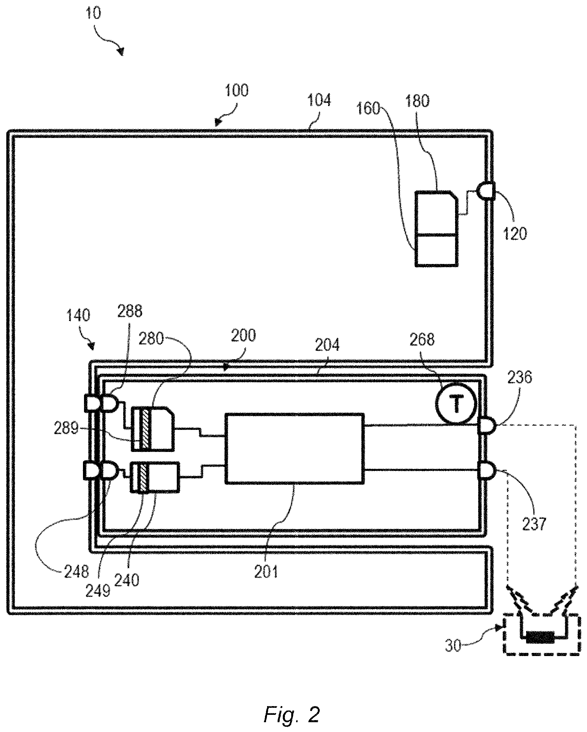

Fig. 2 zeigt ein Prüfsystem 10 nach einer Ausführungsform der vorliegenden Erfindung zur Prüfung einer Elektroenergieeinrichtung mit einem Prüfstrom.

In einem Ausführungsbeispiel weist das Prüfsystem 10 ein portables Hauptgerät 100 mit einem Gehäuse 104, das einen Modulplatz 140 zur Aufnahme und zur Verbindung mit einem Erweiterungsmodul aufweist, und mit einer am Gehäuse 104 angeordneten Anschlussanordnung 120 zur Verbindung mit einem portablen Zusatzgerät auf. Zudem weist das Prüfsystem 10 als das Erweiterungsmodul eine Hochstromquelle 200 auf. In einigen Varianten weist das Prüfsystem 10 zudem wenigstens ein portables Zusatzgerät auf. In anderen Varianten besteht das Prüfsystem 10 aus dem portablen Hauptgerät 100 und der Hochstromquelle 200. Auch weist das Prüfsystem 10 in einigen Varianten keine Anschlussanordnung 120 auf.

Die Hochstromquelle 200 kann wie zuvor beschrieben ausgebildet sein. Weiterhin weist die Hochstromquelle 200 ein Gehäuse 204 für den Modulplatz 140 sowie am Gehäuse 204 angeordnet eine Energieversorgungsanschlussanordnung 248, eine Eingangsanschlussanordnung 288 und einen ersten und einen zweiten Hochstromanschluss 236, 237 auf. Dabei ist der erste Hochstromanschluss 236 mit der ersten Seite des Brückenzweigs und der zweite Hochstromanschluss 237 mit der zweiten Seite des Brückenzweigs elektrisch verbunden. Innerhalb des Gehäuses 204 sind außerdem die Energieversorgungseinrichtung 240 und die Ansteuerungseinrichtung 280 der Hochstromquelle 200 sowie die erste Vielzahl an ersten schaltbaren Halbbrücken und die zweite Vielzahl an zweiten schaltbaren Halbbrücken, die in Form einer integralen Einheit 201 ausgestaltet sind, angeordnet. Auf diese Weise lässt sich die Hochstromquelle 200 als eine Einheit mit dem portablen Hauptgerät 100 zur Erzeugung von Prüfströmen verbinden.

Außerdem weist das portable Hauptgerät 100 eine Messeinrichtung 160 für ein Messen von Messgrößen und eine Steuerungseinrichtung 180 zum Steuern der Messeinrichtung 160 und der Hochstromquelle 200 für eine Prüfung der Elektroenergieeinrichtung auf.

In Fig. 2 ist darüber hinaus auch die Elektroenergieeinrichtung 30 dargestellt. Zum Prüfen und zum Einspeisen des Prüfstroms ist üblicherweise der erste Hochstromanschluss 236 an einen ersten Anschlusspunkt der Elektroenergieeinrichtung 30 anzuschließen und der zweite Hochstromanschluss 237 an einen zweiten Anschlusspunkt der Elektroenergieeinrichtung 30. Zudem kann für einige Messungen/Prüfungen die Messeinrichtung 160 über nicht gezeigte Prüfanschlüsse oder Messanschlüsse an den ersten und/oder zweiten Anschlusspunkt oder an weitere Anschlusspunkte der Elektroenergieeinrichtung 30 anzuschließen sein, etwa um eine elektrische Spannung zwischen dem ersten und zweiten Anschlusspunkt oder etwa einen elektrischen Strom durch wenigstens einen der Anschlusspunkte zu messen, welche bzw. welcher dort aufgrund des Prüfstroms anliegt.

Das portable Hauptgerät 100 ist eingerichtet, die Hochstromquelle 200, wenn sie im Modulplatz 140 aufgenommen ist, über die Eingangsanschlussanordnung 288 zu steuern und über die Energieversorgungsanschlussanordnung 248 mit Energie zu versorgen. Die Energieversorgungseinrichtung 240 ist eingerichtet, über die Energieversorgungsanschlussanordnung 248 elektrische Energie zu empfangen. Die Ansteuerungseinrichtung 280 ist eingerichtet, das Eingangssignal über die Eingangsanschlussanordnung 288 zu empfangen.

In einigen Varianten weist die Energieversorgungseinrichtung 240 eine Komponente zur galvanischen Trennung 249 auf und ist eingerichtet, die positive und negative Versorgungsspannung galvanisch getrennt von der empfangen elektrischen Energie bereitzustellen.

In einigen Varianten weist die Ansteuerungseinrichtung 280 eine Komponente zur galvanischen Trennung 289 auf und ist eingerichtet, die ersten und zweiten schaltbaren Halbbrücken galvanisch getrennt vom Eingangssignal anzusteuern. Dies kann vorteilhaft mit Varianten kombiniert sein, bei welchen die Ansteuerungseinrichtung 280 zum Empfangen eines digitalen Eingangssignals eingerichtet ist. Wie in Fig. 2 dargestellt, weisen einige Varianten der Hochstromquelle 200 eine Temperatursensoreinrichtung 268 auf, die eingerichtet ist, eine Temperatur am ersten oder am zweiten Hochstromanschluss 236, 237 oder an wenigstens einem anderen Ort bei der Hochstromquelle 200 zu erfassen. Dabei ist die Ansteuerungseinrichtung 280 eingerichtet, abhängig davon, ob die Temperatur über einem vorbestimmten Temperaturgrenzwert liegt, einen Fehlermodus der Hochstromquelle 200 zu aktiveren und einen Strom des Ausgangssignals zu begrenzen. Auch können in einigen Varianten im Fehlermodus die Hochstromanschlüsse 236, 237 von der ersten und zweiten Seite des Brückenzweigs mittels Schaltmittel der Hochstromquelle getrennt werden.

Schließlich ist die Hochstromquelle 200 eingerichtet ist, gesteuert durch die Steuerungseinrichtung 180 ein Ausgangssignal zwischen dem ersten 236 und zweiten 237 Hochstromanschluss zu erzeugen und somit den Prüfstrom bereitzustellen. Damit lässt sich vorteilhaft ein einphasiger Prüfstrom zwischen dem ersten 236 und zweiten 237 Hochstromanschluss bereitstellen.

Einige Varianten der Hochstromquelle 200 - hier nicht dargestellt - sind zum Erzeugen eines zwei- bzw. dreiphasigen Prüfstroms eingerichtet. Dazu werden in einigen dieser Varianten die erste Vielzahl an ersten schaltbaren Halbbrücken für eine erste Phase und die zweite Vielzahl an zweiten schaltbaren Halbbrücken für eine zweite Phase verwendet - etwa relativ zu einem Erdungspotenzial oder einer Mittelanzapfung. Zudem weisen einige dieser Varianten einen dritten Hochstromanschluss und eine dritte Vielzahl an dritten schaltbaren Halbbrücken für eine dritte Phase auf. Dabei ist die Ansteuerungseinrichtung eingerichtet, die erste, zweite und dritte Vielzahl basierend auf einem, insbesondere dreiphasigen, Eingangssignal derart anzusteuern, dass jeweils zwischen der ersten und zweiten Vielzahl (also insbesondere zwischen ersten und zweiten Hochstromanschluss), zwischen der zweiten und dritten Vielzahl (also insbesondere zwischen zweiten und dritten Hochstromanschluss) und zwischen der dritten und ersten Vielzahl (also insbesondere zwischen dritten und ersten Hochstromanschluss) je ein Ausgangssignal anliegt, welches insbesondere je einer Phase des Eingangssignals entspricht. Auf diese vorteilhafte lassen sich alle drei Phasen einer, insbesondere dreiphasigen, Elektroenergieeinrichtung mit je einem Prüfstrom - insbesondere gleichzeitig oder ohne Änderung einer Verkabelung - prüfen.

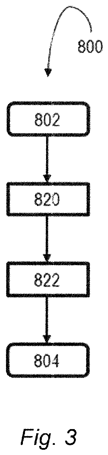

In Fig. 3 ist ein Flussdiagramm einer Verwendung 800 eine Hochstromquelle oder eines Prüfsystems nach einer Ausführungsform der vorliegenden Erfindung zur Prüfung einer Elektroenergieeinrichtung mit einem Prüfstrom dargestellt.

In einem Ausführungsbeispiel weist die Verwendung 800 den Verwendungsstart 802 und das Verwendungsende 804 sowie die Verwendungsschritte 820 und 822 auf. Die verwendete Hochstromquelle und das verwendete Prüfsystem können wie zuvor beschrieben ausgebildet sein.

Im Verwendungsschritt 820 wird mittels der Hochstromquelle bzw. der Hochstromquelle des Prüfsystems der Prüfstrom zu erzeugt.

Im Verwendungsschritt 820 wird mittels einer Messeinrichtung der Hochstromquelle oder des Prüfsystems wenigstens eine Messgröße für die Prüfung gemessen, wobei die wenigstens eine Messgröße auf wenigstens einem Messsignal basiert, welches aufgrund des Prüfstroms erzeugt wird.

In einigen Varianten umfasst die Prüfung wenigstens eine Messung, welche ausgewählt ist aus einer Gruppe umfassend: eine Mikroohm-Messung; eine Wicklungswiderstands-Messung; eine CT-Verhältnis-Messung; und eine Circuit-Breaker-Messung. Hierbei kann die Circuit-Breaker-Messung in einigen Varianten eine "LV-Circuit-Breaker-Messung" an einem Niederspannungs-Leistungsschalter sein.

## Patentansprüche

1. Hochstromquelle (200) für ein Prüfsystem zur Prüfung einer Elektroenergieeinrichtung (30), aufweisend:
eine erste Vielzahl (210) an ersten schaltbaren Halbbrücken (212), die parallel geschaltet sind und durch deren Anzahl ein Prüfstrom redundant aufgeteilt wird;
eine zweite Vielzahl (220) an zweiten schaltbaren Halbbrücken (222), die parallel geschaltet sind und durch deren Anzahl der Prüfstrom redundant aufgeteilt wird; und
eine Ansteuerungseinrichtung (280), welche eingerichtet ist, basierend auf einem Eingangssignal die erste Vielzahl (210) an ersten schaltbaren Halbbrücken (212) und die zweite Vielzahl (220) an zweiten schaltbaren Halbbrücken (222) derart anzusteuern, dass an einem Brückenzweig (230) zwischen den ersten schaltbaren Halbbrücken (212) und den zweiten schaltbaren Halbbrücken (222) ein Ausgangssignal für den Prüfstrom anliegt, welches dem Eingangssignal entspricht,
**dadurch gekennzeichnet, dass**
die Hochstromquelle (200) zur Erzeugung eines Prüfstroms, welcher zur Prüfung einer Elektroenergieeinrichtung (30) eines Energieversorgungsnetzes geeignet ist, eingerichtet ist, und
wobei die erste Vielzahl (210) an ersten schaltbaren Halbbrücken (212) und die zweite Vielzahl (220) an zweiten schaltbaren Halbbrücken (222) eingerichtet sind, um einen Strom von wenigstens 500 A als den Prüfstrom zu erzeugen.

2. Hochstromquelle (200) gemäß Anspruch 1, welche weiterhin aufweist:
einen ersten Hochstromanschluss (236) zum Anschließen eines ersten Anschlusspunkts der Elektroenergieeinrichtung (30); und
einen zweiten Hochstromanschluss (237) zum Anschließen eines zweiten Anschlusspunkts der Elektroenergieeinrichtung (30);
wobei der erste Hochstromanschluss (236) mit der ersten Seite (231) des Brückenzweigs und der zweite Hochstromanschluss (237) mit der zweiten Seite (232) des Brückenzweigs elektrisch verbunden ist;
wobei die ersten schaltbaren Halbbrücken (212) jeweils zwei steuerbare Schaltelemente (216, 217) aufweisen, die mit einer Verbindungsstelle (218) in Reihe geschaltet sind;
wobei die zweiten schaltbaren Halbbrücken (222) jeweils zwei steuerbare Schaltelemente (226, 227) aufweisen, die mit einer Verbindungsstelle (228) in Reihe geschaltet sind;
wobei die Verbindungsstellen (218) der ersten schaltbaren Halbbrücken (212) parallel geschaltet sind und mit einer ersten Seite (231) des Brückenzweigs (230) elektrisch verbunden sind;
wobei die Verbindungsstellen (228) der zweiten schaltbaren Halbbrücken (222) parallel geschaltet sind und mit einer zweiten Seite (232) des Brückenzweigs (230) elektrisch verbunden sind; und
wobei die Ansteuerungseinrichtung (280) eingerichtet ist, die steuerbaren Schaltelemente anzusteuern.

3. Hochstromquelle (200) gemäß Anspruch 2, wobei:
die Verbindungsstellen (218) der ersten schaltbaren Halbbrücken (212) jeweils über ein Filterelement (213) mit der ersten Seite (231) des Brückenzweigs elektrisch verbunden sind; und
die Verbindungsstellen (228) der zweiten schaltbaren Halbbrücken (222) jeweils über ein Filterelement (223) mit der zweiten Seite (232) des Brückenzweigs elektrisch verbunden sind.

4. Hochstromquelle (200) gemäß Anspruch 2 oder Anspruch 3, welche weiterhin eine Temperatursensoreinrichtung (268) aufweist, die eingerichtet ist, eine Temperatur am ersten oder am zweiten Hochstromanschluss (236, 237) zu erfassen; wobei die Ansteuerungseinrichtung (280) eingerichtet ist, abhängig davon, ob die Temperatur über einem vorbestimmten Temperaturgrenzwert liegt, einen Fehlermodus der Hochstromquelle (200) zu aktiveren und einen Strom des Ausgangssignals zu begrenzen.

5. Hochstromquelle (200) gemäß einem der Ansprüche 2 bis 4, welche weiterhin eine positive Versorgungsschiene (242) zum Verteilen einer positiven Versorgungsspannung und eine negative Versorgungsschiene (246) zum Verteilen einer negativen Versorgungsspannung aufweist; wobei je eines der zwei steuerbaren Schaltelemente (216; 226) jeweils der ersten bzw. zweiten schaltbaren Halbbrücken (212; 222) mit der positiven Versorgungsschiene (242) elektrisch verbunden ist und je ein anderes der zwei steuerbaren Schaltelemente (217; 227) jeweils der ersten bzw. zweiten schaltbaren Halbbrücken (212; 222) mit der negativen Versorgungsschiene (246) elektrisch verbunden ist.

6. Hochstromquelle (200) gemäß einem der vorhergehenden Ansprüche, welche weiterhin eine Energieversorgungseinrichtung (240) mit mehreren Doppelschicht-Kondensatoren (241) aufweist, welche eingerichtet ist, für die ersten und zweiten schaltbaren Halbbrücken (212, 222) eine positive Versorgungsspannung und eine negative Versorgungsspannung bereitzustellen und die positive bzw. negative Versorgungsspannung mittels der Doppelschicht-Kondensatoren zu puffern.

7. Hochstromquelle (200) gemäß Anspruch 6, wobei die Energieversorgungseinrichtung (240) eingerichtet ist, über eine Energieversorgungsanschlussanordnung (248) der Hochstromquelle elektrische Energie zu empfangen sowie die positive und negative Versorgungsspannung galvanisch getrennt (249) von der empfangen elektrischen Energie bereitzustellen.

8. Hochstromquelle (200) gemäß einem der vorhergehenden Ansprüche, wobei die Ansteuerungseinrichtung (280) eingerichtet ist, das Eingangssignal über eine Eingangsanschlussanordnung (288) der Hochstromquelle zu empfangen und die ersten und zweiten schaltbaren Halbbrücken (212, 222) galvanisch getrennt (289) vom Eingangssignal anzusteuern.

9. Hochstromquelle (200) gemäß einem der vorhergehenden Ansprüche, welche weiterhin eine Stromsensoreinrichtung (281, 282) mit mehreren Stromsensoren aufweist, wobei die Hochstromquelle (200) eingerichtet ist, einen Gleichspannungs- und/oder Gleichstrom-Offset mittels einer Offset-Regelungseinrichtung der Hochstromquelle zu regeln.

10. Hochstromquelle (200) gemäß einem der vorhergehenden Ansprüche, wobei die Anzahl der ersten oder der zweiten schaltbaren Halbbrücken (212, 222) wenigstens zwanzig ist; und/oder wobei die Anzahl der ersten schaltbaren Halbbrücken (212) gleich der Anzahl der zweiten schaltbaren Halbbrücken (222) ist.

11. Hochstromquelle (200) gemäß einem der vorhergehenden Ansprüche, wobei die erste Vielzahl (210) an ersten schaltbaren Halbbrücken (212) und die zweite Vielzahl (220) an schaltbaren Halbbrücken (222) eingerichtet sind, als den Prüfstrom zumindest einen Wechselstrom mit einer Frequenz von wenigstens 3 kHz oder einen Gleichstrom zu erzeugen.

12. Hochstromquelle (200) gemäß einem der vorhergehenden Ansprüche, wobei die erste Vielzahl (210) an ersten schaltbaren Halbbrücken (212) und die zweite Vielzahl (220) an zweiten schaltbaren Halbbrücken (222) in Form einer integralen Einheit (201) ausgestaltet und in einem gemeinsamen Gehäuse (204) angeordnet sind.

13. Prüfsystem (10) zur Prüfung einer Elektroenergieeinrichtung (30) mit einem Prüfstrom, aufweisend:
ein portables Hauptgerät (100) mit einem Gehäuse (104), das einen Modulplatz (140) zur Aufnahme und zur Verbindung mit einem Erweiterungsmodul aufweist, und einer am Gehäuse (104) angeordneten Anschlussanordnung (120) zur Verbindung mit einem portablen Zusatzgerät; und
eine Hochstromquelle (200) gemäß einem der vorhergehenden Ansprüche als das Erweiterungsmodul;
wobei die Hochstromquelle (200) weiterhin ein Gehäuse (204) für den Modulplatz (140) aufweist sowie am Gehäuse (204) angeordnet eine Energieversorgungsanschlussanordnung (248), eine Eingangsanschlussanordnung (288) und einen ersten und einen zweiten Hochstromanschluss (236; 237);
wobei das portable Hauptgerät (100) weiterhin aufweist:
eine Messeinrichtung (160) für ein Messen von Messgrößen, und
eine Steuerungseinrichtung (180) zum Steuern der Messeinrichtung (160) und der Hochstromquelle (200) für eine Prüfung der Elektroenergieeinrichtung (30);
wobei das portable Hauptgerät (100) eingerichtet ist, die Hochstromquelle (200), wenn sie im Modulplatz (140) aufgenommen ist, über die Eingangsanschlussanordnung (288) zu steuern und über die Energieversorgungsanschlussanordnung (248) mit Energie zu versorgen; und
wobei die Hochstromquelle (200) eingerichtet ist, gesteuert durch die Steuerungseinrichtung (180) ein Ausgangssignal zwischen dem ersten (236) und zweiten (237) Hochstromanschluss zu erzeugen und somit den Prüfstrom bereitzustellen.

14. Verwendung (800) eine Hochstromquelle gemäß einem der Ansprüche 1 bis 12 oder eines Prüfsystems gemäß Anspruch 13 zur Prüfung einer Elektroenergieeinrichtung eines Energieversorgungsnetzes mit einem Prüfstrom.

15. Verwendung (800) gemäß Anspruch 14, wobei die Prüfung wenigstens eine Messung durch eine Messeinrichtung (160) umfasst, welche ausgewählt ist aus einer Gruppe umfassend:
- eine Mikroohm-Messung;
- eine Wicklungswiderstands-Messung;
- eine CT-Verhältnis-Messung; und
- eine Circuit-Breaker-Messung.

## Claims

1. A high-current source (200) for a test system for testing an electrical energy apparatus (30), comprising:
a first plurality (210) of first switchable half-bridges (212) that are connected in parallel and through the number of which a test current is divided redundantly;
a second plurality (220) of second switchable half-bridges (222) that are connected in parallel and through the number of which the test current is divided redundantly; and
a control unit (280) that is configured to control, based on an input signal, the first plurality (210) of first switchable half-bridges (212) and the second plurality (220) of second switchable half-bridges (222) in such a way that an output signal for the test current is present on a bridge branch (230) between the first switchable half-bridges (212) and the second switchable half-bridges (222), which output signal corresponds to the input signal,
**characterized in that** the high-current source (200) is configured for generating a test current adapted for testing an electrical energy apparatus (30) of an energy supply network, and
wherein the first plurality (210) of first switchable half-bridges (212) and the second plurality (220) of second switchable half-bridges (222) are configured to generate a current of at least 500 A as the test current.

2. The high-current source (200) as claimed in claim 1, which furthermore has:
a first high-current connection (236) for connecting a first connection point of the electrical energy apparatus (30); and
a second high-current connection (237) for connecting a second connection point of the electrical energy apparatus (30);
wherein the first high-current connection (236) is electrically connected to the first side (231) of the bridge branch and the second high-current connection (237) is electrically connected to the second side (232) of the bridge branch,
wherein the first switchable half-bridges (212) each have two controllable switching elements (216, 217) that are connected in series with a connecting point (218);
wherein the second switchable half-bridges (222) each have two controllable switching elements (226, 227) that are connected in series with a connecting point (228);
wherein the connecting points (218) of the first switchable half-bridges (212) are connected in parallel and are electrically connected to a first side (231) of the bridge branch (230);
wherein the connecting points (228) of the second switchable half-bridges (222) are connected in parallel and are electrically connected to a second side (232) of the bridge branch (230); and
wherein the control unit (280) is configured to control the controllable switching elements.

3. The high-current source (200) as claimed in claim 2, wherein:
the connecting points (218) of the first switchable half-bridges (212) are each electrically connected to the first side (231) of the bridge branch via a filter element (213); and
the connecting points (228) of the second switchable half-bridges (222) are each electrically connected to the second side (232) of the bridge branch via a filter element (223).

4. The high-current source (200) as claimed in claim 2 or claim 3, which furthermore has a temperature sensor apparatus (268) that is configured to capture a temperature at the first or at the second high-current connection (236, 237); wherein the control unit (280) is configured to activate a fault mode of the high-current source (200) and to limit a current of the output signal depending on whether the temperature is above a predetermined temperature limit value.

5. The high-current source (200) as claimed in any one of claims 2 to 4, which furthermore has a positive supply rail (242) for distributing a positive supply voltage and a negative supply rail (246) for distributing a negative supply voltage; wherein one of the two controllable switching elements (216; 226) of each of the first and second switchable half-bridges (212; 222) is electrically connected to the positive supply rail (242) and a different one of the two controllable switching elements (217; 227) of each of the first and second switchable half-bridges (212; 222) is electrically connected to the negative supply rail (246).

6. The high-current source (200) as claimed in any one of the preceding claims, which furthermore has an energy supply apparatus (240) with a plurality of double-layer capacitors (241) that is configured to provide a positive supply voltage and a negative supply voltage for the first and second switchable half-bridges (212, 222) and to buffer the positive and/or negative supply voltage by means of the double-layer capacitors.

7. The high-current source (200) as claimed in claim 6, wherein the energy supply apparatus (240) is configured to receive electrical energy via an energy supply connection arrangement (248) of the high-current source and to provide the positive and the negative supply voltage in a manner galvanically isolated (249) from the electrical energy received.

8. The high-current source (200) as claimed in any one of the preceding claims, wherein the control unit (280) is configured to receive the input signal via an input connection arrangement (288) of the high-current source and to control the first and second switchable half-bridges (212, 222) in a manner galvanically isolated (289) from the input signal.

9. The high-current source (200) as claimed in any one of the preceding claims, which furthermore has a current sensor apparatus (281, 282) with a plurality of current sensors, wherein the high-current source (200) is configured to regulate a DC voltage offset and/or DC current offset by means of an offset regulation apparatus of the high-current source.

10. The high-current source (200) as claimed in any one of the preceding claims, wherein the number of the first or the second switchable half-bridges (212, 222) is at least twenty; and/or wherein the number of the first switchable half-bridges (212) is equal to the number of the second switchable half-bridges (222).

11. The high-current source (200) as claimed in any one of the preceding claims, wherein the first plurality (210) of first switchable half-bridges (212) and the second plurality (220) of switchable half-bridges (222) are configured to generate at least one AC current with a frequency of at least 3 kHz or a DC current as the test current.

12. The high-current source (200) as claimed in any one of the preceding claims, wherein the first plurality (210) of first switchable half-bridges (212) and the second plurality (220) of second switchable half-bridges (222) are designed in the form of an integral unit (201) and are arranged in a common housing (204).

13. A test system (10) for testing an electrical energy apparatus (30) with a test current, comprising:
a portable main device (100) with a housing (104) that has a module slot (140) for accommodating and connecting to an expansion module, and a connection arrangement (120) arranged on the housing (104) for connecting to a portable additional device; and
a high-current source (200) as claimed in any one of the preceding claims as the expansion module;
wherein the high-current source (200) furthermore has a housing (204) for the module slot (140) and, arranged on the housing (204), an energy supply connection arrangement (248), an input connection arrangement (288) and a first and a second high-current connection (236; 237);
wherein the portable main device (100) furthermore has:
a measuring apparatus (160) for measuring measured variables, and
a control apparatus (180) for controlling the measuring apparatus (160) and the high-current source (200) for testing the electrical energy apparatus (30);
wherein the portable main device (100) is configured to control the high-current source (200), when it is accommodated in the module slot (140), via the input connection arrangement (288) and to supply said high-current source with energy via the energy supply connection arrangement (248); and
wherein the high-current source (200) is configured, controlled by the control apparatus (180), to generate an output signal between the first (236) and the second (237) high-current connection and therefore to provide the test current.

14. The use (800) of a high-current source as claimed in any one of claims 1 to 12 or of a test system as claimed in claim 13 for testing an electrical energy apparatus of an energy supply network with a test current.

15. The use (800) as claimed in claim 14, wherein the test comprises at least one measurement by a measuring apparatus (160) that is selected from a group comprising:
- a microohm measurement;
- a winding resistance measurement;
- a CT ratio measurement; and
- a circuit breaker measurement.

## Revendications

1. Source de courant fort (200) pour un système de contrôle servent à contrôler un dispositif à énergie électrique (30), comprenant :
une première pluralité (210) de premiers demi-ponts commutables (212) qui sont connectés en parallèle et dont le nombre permet de répartir un courant de contrôle de manière redondante ;
une deuxième pluralité (220) de deuxièmes demi-ponts commutables (222) qui sont connectés en parallèle et dont le nombre permet de répartir le courant de contrôle de manière redondante ; et
un dispositif d'entraînement (280) qui est configuré pour entraîner, sur la base d'un signal d'entrée, la première pluralité (210) de premiers demi-ponts commutables (212) et la deuxième pluralité (220) de seconds demi-ponts commutables (222) de manière à ce qu'un signal de sortie pour le courant de contrôle correspondant au signal d'entrée soit appliqué à une branche de pont (230) entre les premiers demi-ponts commutables (212) et les deuxièmes demi-ponts commutables (222),
**caractérisé en ce que** la source de courant fort (200) est configurée pour générer un courant de contrôle servent à contrôler un dispositif à énergie électrique (30) d'un réseau d'alimentation en énergie, et
dans lequel la première pluralité (210) de premiers demi-ponts commutables (212) et la deuxième pluralité (220) de seconds demi-ponts commutables (222) sont configurées pour générer un courant d'au moins 500 A en tant que courant de contrôle.

2. Source de courant fort (200) selon la revendication 1, qui comprend en outre :
une première borne à courant fort (236) pour le raccordement d'un premier point de raccordement du dispositif à énergie électrique (30) ; et
une deuxième borne à courant fort (237) pour le raccordement d'un premier point de raccordement du dispositif à énergie électrique (30) ;
dans lequel la première borne à courant fort (236) est connectée électriquement au premier côté (231) de la branche de pont et la deuxième borne à courant fort (237) est connectée électriquement au deuxième côté (232) de la branche de pont ;
les premiers demi-ponts commutables (212) comportant chacun deux éléments de commutation commandables (216, 217) connectés en série avec un point de connexion (218) ;
les deuxièmes demi-ponts commutables (222) comportant chacun deux éléments de commutation commandables (226, 227) connectés en série avec un point de connexion (228) ;
dans lequel les points de connexion (218) des premiers demi-ponts commutables (212) sont connectés en parallèle et sont connectés électriquement à un premier côté (231) de la branche de pont (230) ;
dans lequel les points de connexion (228) des deuxièmes demi-ponts commutables (222) sont connectés en parallèle et sont connectés électriquement à un deuxième côté (232) de la branche de pont (230) ; et
dans lequel le dispositif d'entraînement (280) est configuré pour entraîner les éléments de commutation commandables.

3. Source de courant fort (200) selon la revendication 2, dans laquelle :
les points de connexion (218) des premiers demi-ponts commutables (212) sont chacun connectés électriquement au premier côté (231) de la branche de pont par l'intermédiaire d'un élément de filtre (213) ; et
les points de connexion (228) des deuxièmes demi-ponts commutables (222) sont chacun connectés électriquement au deuxième côté (232) de la branche de pont par l'intermédiaire d'un élément de filtre (223).

4. Source de courant fort (200) selon la revendication 2 ou la revendication 3, comprenant en outre un dispositif capteur de température (268) configuré pour détecter une température au niveau de la première ou de la deuxième borne à courant fort (236, 237) ; le dispositif d'entraînement (280) étant configuré pour activer un mode d'erreur de la source de courant fort (200) et limiter un courant du signal de sortie, selon que la température est supérieure à une limite de température prédéterminée.

5. Source de courant fort (200) selon l'une quelconque des revendications 2 à 4, qui comprend en outre un rail d'alimentation positif (242) pour distribuer une tension d'alimentation positive et un rail d'alimentation négatif (246) pour distribuer une tension d'alimentation négative ; dans laquelle l'un des deux éléments de commutation commandables (216 ; 226) respectivement des premier et deuxième demi-ponts commutables (212 ; 222) est connecté électriquement au rail d'alimentation positif (242) et l'autre des deux éléments de commutation commandables (217 ; 227) respectivement des premier et deuxième demi-ponts commutables (212 ; 222) est connecté électriquement au rail d'alimentation négatif (246).

6. Source de courant fort (200) selon l'une quelconque des revendications précédentes, qui comprend en outre un dispositif d'alimentation en énergie (240) avec plusieurs condensateurs à double couche (241), qui est configuré pour fournir une tension d'alimentation positive et une tension d'alimentation négative pour les premier et deuxième demi-ponts commutables (212, 222) et pour tamponner la tension d'alimentation positive ou négative au moyen des condensateurs à double couche.

7. Source de courant fort (200) selon la revendication 6, dans laquelle le dispositif d'alimentation en énergie (240) est configuré pour recevoir de l'énergie électrique par l'intermédiaire d'un ensemble de raccordement d'alimentation en énergie (248) de la source de courant fort, ainsi que pour fournir les tensions d'alimentation positive et négative isolées galvaniquement (249) de l'énergie électrique reçue.

8. Source de courant fort (200) selon l'une quelconque des revendications précédentes, dans laquelle le dispositif d'entraînement (280) est configuré pour recevoir le signal d'entrée par l'intermédiaire d'un ensemble de raccordement d'entrée (288) de la source de courant fort et pour entraîner les premier et deuxième demi-ponts commutables (212, 222) isolés galvaniquement (289) du signal d'entrée.

9. Source de courant fort (200) selon l'une quelconque des revendications précédentes, qui comprend en outre un dispositif capteur de courant (281, 282) avec plusieurs capteurs de courant, la source de courant fort (200) étant configurée pour réguler un décalage de tension continue et/ou de courant continu au moyen d'un dispositif de régulation de décalage de la source de courant fort.

10. Source de courant fort (200) selon l'une quelconque des revendications précédentes, dans laquelle le nombre de premiers ou seconds demi-ponts commutables (212, 222) est d'au moins vingt ; et/ou dans laquelle le nombre de premiers demi-ponts commutables (212) est égal au nombre de seconds demi-ponts commutables (222).

11. Source de courant fort (200) selon l'une quelconque des revendications précédentes, dans laquelle la première pluralité (210) de premiers demi-ponts commutables (212) et la deuxième pluralité (220) de demi-ponts commutables (222) sont configurées pour générer le courant de contrôle d'au moins un courant alternatif à une fréquence d'au moins 3 kHz ou un courant continu.

12. Source de courant fort (200) selon l'une quelconque des revendications précédentes, dans laquelle la première pluralité (210) de premiers demi-ponts commutables (212) et la seconde pluralité (220) de seconds demi-ponts commutables (222) sont configurées sous la forme d'une unité intégrale (201) et sont disposées dans un boîtier commun (204).

13. Système de contrôle (10) servant à contrôler un dispositif à énergie électrique (30) avec un courant de contrôle, comprenant :
un appareil principal portable (100) comprenant un boîtier (104) qui présente un emplacement de module (140) servant à recevoir et à être connecté à un module d'extension, et un ensemble de raccordement (120) disposé sur le boîtier (104) pour la connexion à un appareil supplémentaire portable ; et
une source de courant fort (200) selon l'une des revendications précédentes en tant que module d'extension ;
dans lequel la source de courant fort (200) comprend en outre un boîtier (204) pour l'emplacement de module (140) et, disposés sur le boîtier (204), un ensemble de raccordement d'alimentation en énergie (248), un ensemble de raccordement d'entrée (288) et des première et deuxième bornes à courant fort (236 ; 237) ;
dans lequel l'appareil principal portable (100) comprend en outre :
un dispositif de mesure (160) pour mesurer des grandeurs de mesure, et
un dispositif de commande (180) pour commander le dispositif de mesure (160) et la source de courant fort (200) pour un contrôle du dispositif à énergie électrique (30) ;
dans lequel l'appareil principal portable (100) est configuré pour commander la source de courant fort (200), lorsqu'elle est reçue dans l'emplacement de module (140), par l'intermédiaire de l'ensemble de raccordement d'entrée (288) et pour l'alimenter en énergie par l'intermédiaire de l'ensemble de raccordement d'alimentation en énergie (248) ; et
dans lequel la source de courant fort (200) est configurée pour générer un signal de sortie entre la première (236) et la deuxième (237) bornes à courant fort commandé par le dispositif de commande (180) et ainsi fournir le courant de contrôle.

14. Utilisation (800) d'une source de courant fort selon l'une quelconque des revendications 1 à 12 ou d'un système de contrôle selon la revendication 13 servent à contrôler un dispositif à énergie électrique d'un réseau d'alimentation en énergie avec un courant de contrôle.

15. Utilisation (800) selon la revendication 14, dans laquelle le contrôle comprend au moins une mesure par un dispositif de mesure (160) sélectionné dans un groupe comprenant :
- une mesure de micro-ohms ;
- une mesure de la résistance des enroulements ;
- une mesure du rapport CT ; et
- une mesure du disjoncteur.
